# EUROPEAN PATENT APPLICATION

(11) **EP 0 848 081 A2**
(43) Date of publication of application: **17.06.1998**
(21) Application number: 97310166.0
(22) Date of filing: 16.12.1997
(51) Int. Cl.: C23C 14/35, H01J 37/34

(54) **Method and apparatus for physical vapour deposition**

(30) Priority: 16.12.1996 US 771338
(71) Applicant: APPLIED MATERIALS, INC., Santa Clara, California 95054-3299 (US)
(72) Inventor: Nulman, Jaim, Palo Alto, California 94306 (US); Ramaswami, Seshadri, San Jose, California 95118 (US)
(74) Representative: Bayliss, Geoffrey Cyril

(57) **Abstract**

The disclosure relates to an apparatus and method for reducing the likelihood that backsputtered material will be deposited on the target while also enhancing target erosion uniformity and efficiency. A target assembly (90) is provided having multiple units or sections (51, 53) separately biased at different bias potentials to provide sputtering of units comprised of target material and preventing backsputtered material from depositing on the target units which are minimally sputtered and preferably biased at a lower potential. A method is provided for separately biasing multiple units of a target structure to provide sputtering of units biased at a higher potential and preventing deposition of backsputtered material on units biased at a lower potential.

## Description

This invention relates generally to physical vapor deposition (PVD) of thin films of materials from a target source onto a wafer or substrate such as in the manufacture of integrated electronic circuits. More particularly, the invention relates to methods for improving the uniformity of target erosion and efficient utilization of target material in PVD processes while reducing redeposition of particles on the target.

Physical vapor deposition (PVD) or sputtering is a known technique used in the manufacture of integrated circuits. In PVD, a target of a desired coating material is bombarded by ions accelerated thereto to dislodge and eject target material from the target which are then deposited onto a substrate or wafer. The target and the wafer to be coated are generally placed in a vacuum chamber which is evacuated to and maintained at a pressure of less than 10 milliTorr. Typically, a heavy inert gas, such as argon,is supplied to the vacuum chamber and a pumping system maintains the desired gas pressure in the chamber. A glow discharge plasma is created in the low pressure argon, at least partially ionizing the gas, by supplying a high negative DC, AC or RF potential to a cathode (typically the target) and grounding the chamber walls and an anode (typically the substrate). The glow disharge plasma is created in the space between the cathode and the anode, and is generally separated from the electrodes by a dark space or plasma sheath. Since the plasma itself is a good conductor, the plasma remains at essentially a constant positive potential with respect to the negatively biased cathode. This produces an electric field at the target that is substantially perpendicular to the exposed surface of the target. Thus, positive ions from the plasma are accelerated across the dark space onto the exposed surface of the target on trajectories substantially perpendicular to the exposed front surface of the target resulting in sputtering of the target

In planar magnetron sputtering, the density of ion bombardment at the target surface is enhanced by producing a magnetic field in the plasma sheath adjacent the target that helps trap and deflect electrons near the target. Permanent magnets or electromagnets are located behind the target, or on the backing plate onto which the target is mounted, to produce a magnetic field parallel to the surface of the target. Plasma electrons spiral along these magnetic field lines and increase the electron density in these regions. The increased electron density contributes to additional gas ionization in these regions which leads to increased target bombardment and sputtering of the target between the poles of the magnets creating a pattern of target erosion. Physically rotating an off-axis magnet arrangement on the backing of the target may be used to control and alter the pattern of target erosion.

Typically, a racetrack pattern is formed in the target between the poles of the magnets where the target erodes more rapidly. The other areas ofthe target are eroded more slowly, and may not be eroded at all, thereby allowing redeposition or back sputtering of particles onto the target. Backsputtered particles tend to loosely adhere to the surface on which they are deposited and tend to flake off over time. In addition, this leaves a substantial portion of the target unused when the areas between the poles have been eroded.

It is important that replacement of the target occur before the target is eroded down to the backing plate on which the target is attached. Particles sputtered from the backing plate material which reach the workpiece would seriously contaminate or destroy the workpiece. Consequently, a target is typically replaced before the target has been fully utilized leaving expensive target material unused. Since expensive target materials would thereby be wasted, it would be desirable if other means to assure uniform target erosion across the surface could be employed.

U.S. Patent Nos. 5,320,728 and 5,242,566, which are assigned to the assignee of the present invention, teach the design of magnetron arrays to enhance target erosion uniformity. Other techniques such as the use of masks or blocking media placed over the target have been used to prevent redeposition of material onto the target. All magnetron targets, however, generally have areas of re-deposition on the target surface caused by target material becoming ionized either during or after sputtering and being deposited onto the target surface between the sputtering grooves formed by the high negative potential applied thereto. Masking surfaces do not prevent deposition of backsputtered particles on the masking surface and are ill prepared to receive sputtered target material. Accordingly, when backsputtered material is deposited on the target or mask, the material tends to loosely adhere to the surface and can flake off and contaminate the chamber.

Therefore, there remains a need for a target source and sputtering system which enables efficient use of target material and which reduces the likelihood that back sputtered material will deposit on the target and become a particle source.

The present invention provides an apparatus and method for enhancing target face erosion uniformity and for preventing redeposition of material on the target surface. According to one embodiment of the present invention, a target is provided having an annulus laid down over a backing plate in a concentric, toroidally shaped section with an electrically conductive shield disposed within the annulus. The shield is grounded or biased to repel backsputtered material from the shield or to resputter backsputtered material which may deposit on the shield. A magnet assembly or source is preferably located behind the target to trap electrons near the target surface and enhance sputtering of the target. Two different electrical potentials, V_{P1} and V_{P2}, are applied to the target and the shield, respectively, to cause sputtering of the target and to repel backsputtered material from the shield. The voltage V_{P1} applied to the shield is from about 200 to about 800 volts less than V_{P2}, the voltage applied to the target toroid. Thus, the shield is less attractive, hence repulsive, to ions from the plasma or material re-sputtered from the target surface or other chamber surfaces. By varying the voltage difference between V_{P1} and V_{P2} over the range of about 200 to about 800 volts negative, the erosion rate on the target surface can be controlled and confined to the target material, while backsputtered material is repelled from the areas between the sputtered areas of the target.

In a second embodiment, a single target/cathode is provided having multiple units or sections, preferably including an outer toroid unit and an inner annular unit. Each separate cathode unit can have its own magnetron section disposed adjacent thereto and is preferably separately biased at different electrical potentials V_{P1,} V_{P2} ... V_{Pn}. The magnetic field, the target diameter and the potential applied to the units or sections can be determined based on the desired deposition profile on the substrate and the re-deposition on the target face. For example, V_{P2} can be varied to be more or less negative than V_{P1} to thereby selectively attract or repel ions to different portions of the target face, thereby controlling the sputtering rate across the target face and thus affecting the deposition profile on the substrate. The space between the units is defined by the dark space requirements at the selected operating to prevent plasma generation in the region, between the target units or sections.

So that the manner in which the above recited features, advantages and objects of the present invention are attained and can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.
Figure 1A is a top schematic cross section view taken along line 1A-1A of Figure 1B of a magnetron lid assembly;
Figure 1B is a side schematic cross sectional view taken along line 1B-1B of Figure 1A of the magnetron lid assembly of Figure 1A;
Figure 2 is a sputtering system using the magnetron assembly of Figures 1A and 1B wherein the magnetron lid assembly of Figures 1A and 1B forms the lid of the vacuum system of Figure 2;
Figure 3 is a schematic drawing showing the target/shield and bias layout according to one embodiment of the present invention; and
Figure 4 is a schematic drawing showing a second embodiment of a target showing the target units or sections and bias layout according to another embodiment of the present invention.

The present invention generally provides a target structure which reduces the likelihood that backsputtered particles will deposit on the target and which provides uniform erosion and efficient utilization of target material. The target structure includes separate units or sections which are preferably separately, biased to attract or repel ions from the different sections of the target structure to promote sputtering of target material and to prevent deposition of backsputtered particles on the target where forward sputtering is minimal. A method of the present invention provides separate bias potentials applied to the different sections or units of the target structure to control both sputtering and deposition of backsputtered particles on the target.

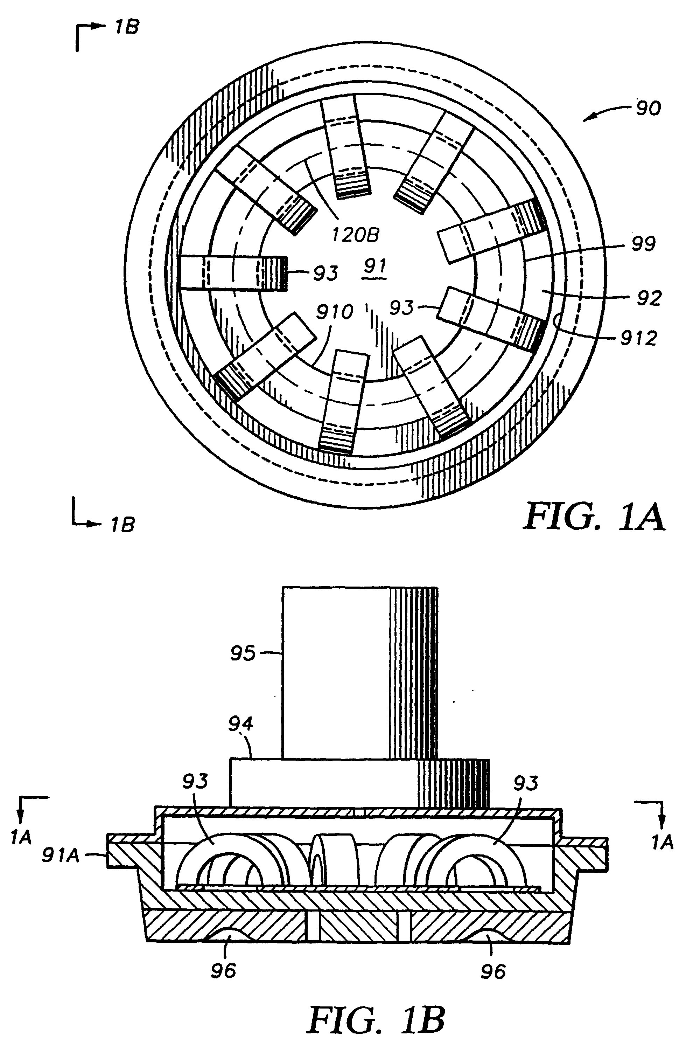

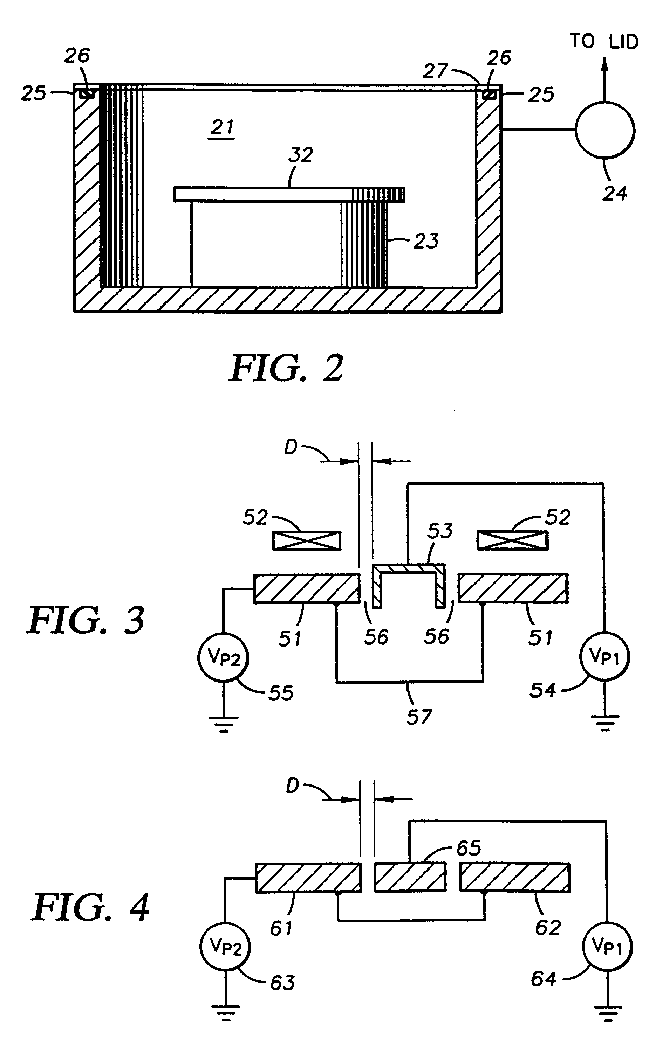

Referring to Figures 1A, 1B and 2, a schematic drawing shows a magnetron sputtering system in accordance with the present invention. Figures 1A and 1B show schematic top and side views of a magnetron assembly and target structure shown generally at 90. Ferromagnets 93, shown as simple horseshoe magnets, and pole pieces 91 and 92 are located behind the target to enhance sputtering of the target and enable the production of PVD coatings having uniform thickness and excellent step coverage on a substrate. A sputtering system includes a vacuum chamber 21, as shown in Figure 2, which has sidewalls 22 formed of a metal such as stainless steel or aluminum. The magnetron assembly and target structure 90 also functions as the lid 91A for the chamber 21 within which a vacuum of about 10 milliTorr can be produced. A target 41 is attached to the underside of the lid and will be discussed in more detail below with reference to Figures 3 and 4. Target 41 is formed of a desired material which is deposited on the substrate 32. The substrate 32 is supported by a substrate support member 23 for processing. A voltage source 24, which may comprise an RF, DC, AC or pulsed DC source, is applied to the target 41 to produce a potential difference between the target 41 and the sidewalls 22, which are typically grounded, to accelerate ions onto the target 41 to sputter target material onto the substrate 32.

The top of the sidewalls 22 includes a groove around the perimeter into which is inserted an elastomeric o-ring 26. The o-ring 26 forms a vacuum seal between the lid assembly and the sidewalls 22. An non-conductive annular ring 27 which is formed of a material such as Teflon or a ceramic is typically disposed on the top of the sidewalls to enable a voltage difference to be produced between the sidewalls 22 and the lid 90. Because of heat generated during processing, a cooling plate or chamber 94, which also serves as a mount for motor 95, is thermally connected by conduction to the target 41. To enhance cooling of target 41, the lid 90 may be formed of a heat conductive material such as copper.

The magnetron assembly 90 includes pole pieces 91 and 92, magnets 93, lid 91A, target 41 and water cooled motor mount 94, which couples the magnet assembly to the electric motor 95. All of the magnets 93 have the same polarity poles overlying pole piece 91 and also pole piece 92. Motor 95 rotates the magnets 93 and their pole pieces 91 and 92 about an axis A centered over the pedestal 23. This produces a time averaged magnetic field and sputtering pattern on target 41 which is typically circularly symmetric. Erosion grooves 96 and 97 are etched into the target face 41 during the sputtering process as electrons are trapped in the magnetic field adjacent the target surface. As can be seen, however, considerable target material still remains on the face of target 41 between grooves 96 and 97 when grooves 96 and 97 become deep enough to threaten erosion completely through target 41. Such material would, prior to the methods of the present invention, be wasted as target 41 would be replaced before the target is completely eroded in grooves 96 and 97.

Referring now to Figures 3 and 4, the biasing techniques of the present invention are illustated schematically with respect to two different embodiments. In one embodiment, shown in Figure 3, a target 51 is provided which is biased at a voltage V_{P1} by a bias power supply 55. Bias power supply 55 provides a negative bias on target 51 to attract ions from the argon plasma onto it to cause sputtering. Magnets 52 trap plasma electrons near the target surface as previously described and cause circularly symmetric erosion grooves analogous to grooves 96 and 97 to be formed primarily in the region between the pole pieces. An annulus 56 in the area central to the target and between magnets 52 is provided with a shield 53 disposed therein which is biased at a different voltage V_{P2}. V_{P2} is about 200 to about 800 volts less negative than voltage V_{P1} which biases the target material so that the shield 53 is less negative with respect to the plasma than the target 51 and thereby tends to repel target ions sputtered from the target surface.

Referring now to Figure 4, a second embodiment of the invention is shown in a schematic view where a single target/cathode is formed of separate units 61, 62, and 65. While only three such units are shown here, it should be understood that four or more units could be used, if desired. Each target unit/cathode can have its own magnetron and its own bias voltage supply 63 and 64. Here, bias voltage supply 63 biases target section 65 at a bias voltage V_{P2}. A second bias supply 64 biases target/cathode sections 61 and 62 at a bias V_{P1}. Again, V_{P2} is about 200 to about 800 volts less negative than V_{P1} and hence tends to repel ions sputtered from target sections 61 and 62 and prevent backsputtered material from depositing onto target section 65.

In Figures 3 and 4, a small distance D separates the target units or sections 51, 61 and 62 from the separate differently biased section 65 or shield 53. This distance D is chosen to be small enough to prevent plasma ignition in its space. Thus, for a given operating pressure and operating voltage, a maximum value of D can be determined. It will also be appreciated that if, in the embodiment shown in Figure 4, four or more target/cathode sections are used, that each target section could have a different bias voltage V_{Pn} as desired. The bias voltages V_{Pn} could be tailored to selectively attract or repel sputtered ions from the target surface to prevent re-deposition and to improve and make more uniform the target erosion profile.

It will be appreciated by those of skill in the art that power supplies used for biasing purposes in these techniques could be DC, pulsed DC, AC or RF supplies as desired.

While the foregoing is directed to the preferred embodiment of the present invention, other and further embodiments of the invention may be devised without departing from the basic scope thereof, and the scope thereof is determined by the claims which follow.

## Claims

1. A target structure for physical vapor deposition, comprising:
(a) a first target section;
(b) a second target section;
(c) a first bias potential connected to the first target section; and
(d) a second bias potential connected to the second target section.

2. The target structure of claim 1, further comprising a magnet assembly disposed behind the first target section.

3. The target structure of claim 2, further comprising a second magnet assembly disposed behind the second target section.

4. The target structure of claim 3, further comprising a backing member on which the target sections are attached on a first side and the magnet assemblies are disposed on the opposite side.

5. The target structure of claim 1, wherein the second target section is a shield member.

6. The target structure of claim 5, wherein the shield member is an annular member.

7. The target structure of claim 5, wherein the first target section is comprised of the target material.

8. The target structure of claim 7, wherein the shield is comprised of the target material.

9. The target structure of claim 1, wherein the second bias potential is less than the first bias potential.

10. The target structure of claim 9, wherein the second bias potential is from about 200V to about 800V less than the first bias potential.

11. The target structure of claim 3, wherein the target sections are made of a target material.

12. The target structure of claim 10, wherein the target sections are mounted on a backing plate.

13. A method for improving the erosion profile of a target material in a glow discharge plasma physical vapor doposition system comprising the steps of:
(a) providing a vacuum chamber having an extremely low pressure inert gas atmosphere therein;
(b) providing in said chamber a workpiece to be coated with a thin film of material as an anode;
(c) providing in said chamber a cathode of a target material separated into plural sections, each said section of target material being biased at a separate predetermined voltage with respect to ground potential; and
(d) maintaining a glow discharge in said low pressure inert gas atmosphere in said chamber, whereby positive ions of said inert gas are accelerated to said target cathode and sputter material therefrom onto said workpiece and ions sputtered from said target are repelled by said predetermined voltage biases from re-depositing onto said target in selected sections thereof.

14. The method of claim 13 and further including the step of providing selected ones of said plural sections of target material with magnetrons to enhance ion generation near the surface thereof.

15. The method of claim 14 wherein said cathode of target material is separated into sections having a distance D between each pair thereof.

16. The method of claim 3 wherein said target sections form annular discs of target material each pair of which is separated by a distance D.

17. The method of claim 16 wherein pairs of annular discs of target material are separated by shield material which is also biased by a predetermined voltage to repel ions of sputtered target material from depositing thereon.

18. The methods of claims 15, 16 and 17 wherein the distance D is chosen to be too small to allow a glow discharge to form in the space between said target sections or said shield and said target sections.

19. A method of more efficiently eroding the surface of a target material used in a glow discharge physical vapor deposition process for depositing thin films of target material onto a wafer or substrate workpiece, comprising the steps of:
(a) providing a glow discharge vacuum system operating at a low inert gas pressure of less than 10 milliTorr and having a wafer or substrate anode and a target material cathode divided into separate sections electrically isolated form each other and selected ones of which have associated therewith a magnetron to enhance ionization near the surface thereof and at least two separate bias power supplies for applying at least two separate electrical biases to said separate sections of target material; and
(b) maintaining a glow discharge in an inert gas atmosphere in said system while rotating said magnetrons to generate sputtered atoms and ions of said target material which are uniformly deposited on said substrate anode, while arranging said at least two separate electrical biases to repel sputtered ions of target material from being re-deposited onto said target material.

20. The method of claim 19 wherein said separate target sections are separated from each other by a shield, said shield being electrically biased to repel sputtered ions of target material from being re-deposited onto thereon.

21. The method of claim 19 wherein said separate sections oftarget material are separated by a distance D too small to support a glow discharge therein.

22. The method of claim 19 wherein the rotation of said magnetrons produces erosion grooves in said target material associated with said magnetrons and wherein said biases are arranged to enhance target material erosion in the target areas between said erosion grooves.

23. The method of claim 7 wherein said target material is separated into sections forming annular discs with to the axis of rotation of said magnetrons.
